# DEMANDE DE BREVET EUROPEEN

(11) **EP 4 766 102 A1**
(43) Date de publication de la demande: **24.06.2026**
(21) Numéro de dépôt: 25223565.0
(22) Date de dépôt: 15.12.2025
(51) Int. Cl.: H10F 77/1223, H10F 71/00

(54) **CELLULE SOLAIRE EN SI CRISTALLIN PLUS RESISTANTE AUX IRRADIATIONS**

(30) Priorité: 19.12.2024 FR 2414652
(71) Demandeur: Commissariat à l'Energie Atomique et aux Energies Alternatives, 75015 Paris (FR)
(72) Inventeur: DUBOIS, Sébastien, 38054 GRENOBLE Cedex 09 (FR); ENJALBERT, Nicolas, 38054 GRENOBLE Cedex 09 (FR); CARIOU, Romain, 38054 GRENOBLE Cedex 09 (FR)
(74) Mandataire: Santarelli

(57) **Abrégé**

Substrat (10) en silicium cristallin pour cellule solaire en particulier dans le domaine du spatial, ledit substrat ayant une conductivité de type P et étant dopé à l'aide d'au moins une espèce dopante de type accepteur dans le silicium, cette espèce dopante ayant une concentration p0 à l'équilibre supérieure à 1017 atomes par cm3.

## Description

### DOMAINE TECHNIQUE ET ART ANTERIEUR

La présente demande concerne le domaine des cellules solaires encore appelées cellules photovoltaïques (PV) et en particulier celles utilisées dans des environnements soumis à de fortes irradiations par les électrons et les protons tels que dans le domaine du spatial.

La demande concerne plus particulièrement un substrat amélioré pour cellule solaire et une cellule munie d'un tel substrat et prévue notamment pour une utilisation dans l'espace.

Pour une application spatiale et une cellule dotée d'un substrat en silicium cristallin, on préfère généralement prévoir ce substrat avec un dopage de type p plutôt qu'une conductivité n. Le silicium cristallin dopé p est en effet connu pour être moins sensible aux défauts créés par l'irradiation que le silicium cristallin dopé n.

Typiquement, la résistivité d'un substrat en silicium cristallin (c-Si) utilisé pour la fabrication de cellules solaires est comprise dans une gamme entre 0,3 Ω.cm et 30 Ω.cm.

Le document « Electron and proton damage coefficients in low-resistivity silicon », de Srour, J et al. (1975), IEEE Transactions on Nuclear Science, 22(6), 2656-2662, montre que la dégradation de la longueur de diffusion des porteurs minoritaires de substrats c-Si de type p sous irradiation électrons est d'autant plus forte, pour une fluence donnée, que la résistivité du substrat est faible.

Pour permettre d'améliorer la résistance d'un substrat à base de c-Si aux irradiations l'article « Investigation of p-type silicon heterojunction radiation hardness", de Cariou et al. (2023). IEEE Journal of Photovoltaics, propose quant à lui de réduire l'épaisseur d'un substrat en silicium.

Il se pose le problème de trouver un nouveau moyen pour rendre une cellule solaire moins sensible aux irradiations.

### EXPOSÉ DE L'INVENTION

C'est par conséquent un but de la présente invention d'offrir un substrat en silicium cristallin (c-Si) pour cellule solaire qui présente une résistance accrue aux irradiations par les électrons et les protons.

Les inventeurs ont constaté, de façon inattendue et contraire aux enseignements de l'art antérieur, qu'un dopage important d'un substrat en silicium cristallin et en particulier avec une concentration en trous à l'équilibre (p₀) supérieure à 10¹⁷ cm⁻³, permettait d'obtenir une résistance aux irradiations nettement améliorée, pour une cellule solaire dotée d'un tel substrat.

Selon un aspect, la présente invention concerne ainsi un substrat en silicium cristallin pour cellule solaire, ce substrat ayant une conductivité de type p et étant dopé à l'aide d'au moins une espèce dopante de type accepteur dans le silicium, de manière à ce que la concentration de trous à l'équilibre p₀ soit strictement supérieure à 10¹⁷ cm⁻³ et typiquement inférieure à 10¹⁸ cm⁻³.

De préférence, également pour le rendre moins sensible aux conséquences de fortes irradiations, le substrat est en outre prévu avec une faible concentration en oxygène dans le silicium cristallin et en particulier inférieure à 3*10¹⁷ atomes par cm³ et typiquement comprise entre 10¹⁴ et 10¹⁷ atomes par cm³.

Avantageusement, la concentration de trous à l'équilibre p₀ est prévue supérieure à 1.5*10¹⁷ cm⁻³, tandis que la concentration en oxygène est inférieure ou égal à 10¹⁷ atomes par cm³, de préférence inférieure à 9*10¹⁶ atomes par cm³.

Le substrat a une première face principale et une deuxième face principale opposée à la première face principale.

Une concentration en oxygène telle que définie plus haut est prévue sur tout le substrat, depuis la première face principale jusqu'à la deuxième face principale.

De même, la concentration de trous à l'équilibre p₀ définie plus haut est prévue sur tout le substrat, depuis la première face principale jusqu'à la deuxième face principale.

De préférence, le substrat a une épaisseur mesurée de la première face principale à la deuxième face principale comprise entre 20 µm et 180 µm.

Avantageusement, on prévoit cette épaisseur comprise entre 40 µm et 120 µm, de préférence entre 60 et 120 µm et encore plus avantageusement entre 80 et 120 µm.

De préférence, le silicium du substrat est monocristallin ou majoritairement monocristallin.

Au moins une espèce dopante de type accepteur utilisée pour permettre de réaliser un dopage de type p peut être choisie en particulier parmi : B, Ga, Al.

Selon un mode de réalisation particulier, le substrat peut être dopé en outre :
- à l'aide d'au moins une espèce neutre (isovalente) telle que le germanium ou l'étain et/ou,
- à l'aide d'au moins un élément léger tel que de l'hydrogène ou du lithium et/ou,
- à l'aide d'une espèce donneuse telle que l'antimoine.

Par élément « léger » on entend typiquement un élément de numéro atomique inférieur ou égal à 5.

Selon un autre aspect, la présente invention concerne une cellule solaire dotée d'un substrat tel que défini précédemment et en particulier une cellule solaire adaptée à des applications spatiales.

Avantageusement, cette cellule solaire peut comprendre au moins un empilement de contact passivé sur une première face du substrat, l'empilement de contact passivé étant formé :
- d'une couche de passivation, telle qu'une couche en oxyde de silicium ou en silicium amorphe intrinsèque a-Si(i), directement en contact avec la première face,
- d'une couche sélective d'électrons, en particulier une couche de silicium amorphe dopé n, ou une couche de silicium nanocristallin dopé n, ou une couche de silicium polycristallin dopé n, directement en contact avec la couche de passivation.

Selon une possibilité de mise en œuvre de la cellule solaire, cette cellule peut comprendre en outre au moins un autre empilement de contact passivé sur une deuxième face du substrat opposée à la première face, l'autre empilement de contact passivé étant formé :
- d'une autre couche de passivation, telle qu'une couche en oxyde de silicium ou en silicium amorphe intrinsèque a-Si(i), directement en contact avec la deuxième face,
- d'une couche sélective de trous, en particulier une couche de silicium amorphe dopé p, ou une couche de silicium nanocristallin dopé p, ou une couche de silicium polycristallin dopé p, directement en contact avec la couche de passivation.

Avantageusement, l'empilement de contact passivé est revêtu d'au moins une couche d'au moins un oxyde transparent conducteur, de électrodes métalliques étant agencées sur la couche d'oxyde transparent conducteur.

Selon un autre aspect, la présente invention concerne également un module photovoltaïque pour dispositif spatial tel qu'un satellite, une station spatiale, un véhicule spatial, une sonde, un bâtiment, et comprenant une ou plusieurs cellules solaires telles que définies précédemment.

Selon un autre aspect, la présente invention concerne également un procédé de fabrication d'un substrat tel que défini plus haut et comprenant l'une des méthodes suivantes :
- Solidification dirigée en creuset ou ;
- Croissance par épitaxie sur un support parent doté d'une couche poreuse puis détachement du support poreux ou ;
- Cristallisation par zone fondue ;
- Tirage de Czochralski effectué sous champ magnétique.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
La figure 1 sert à illustrer un substrat en silicium cristallin dopé p pour cellule photovoltaïque avec une forte concentration en dopants et avec une faible concentration en oxygène afin de rendre la cellule résistante aux effets de fortes irradiations telles que celles que l'on peut retrouver hors de l'atmosphère terrestre.
La figure 2 sert à illustrer un exemple de cellule solaire à contacts passivés et munie d'un tel substrat pour des applications notamment dans le domaine du spatial.
La figure 3 sert à illustrer un autre exemple de cellule solaire à contacts passivés.

Des parties identiques, similaires ou équivalentes des différentes figures portent les mêmes références numériques de façon à faciliter le passage d'une figure à l'autre ;

Les figures 4A et 4B servent à illustrer la résistance aux irradiations d'une cellule solaire mise en œuvre avec un tel substrat.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

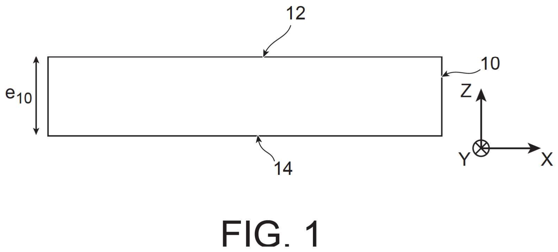

On se réfère à présent à la figure 1 qui représente de manière schématique un substrat 10 pour cellule solaire, typiquement sous forme d'une plaque ou d'une plaquette. La cellule solaire que l'on réalise à partir de ce substrat 10 est en particulier une cellule solaire destinée à être utilisée dans un environnement soumis à de fortes irradiations, tel qu'un environnement spatial.

Par environnement à « forte irradiation », on désigne en particulier un environnement dont les principaux effets correspondent à une exposition à une irradiation équivalente par électrons d'énergie voisine ou d'au moins 1 MeV pour une fluence supérieure à 10¹³ électrons par cm².

Le substrat 10 est à base de silicium cristallin (c-Si), avantageusement du silicium monocristallin ou majoritairement monocristallin, et prévu avec une conductivité de type p.

Le substrat 10 a une épaisseur typiquement comprise entre 20 µm et 180 µm.

Le substrat 10 a pour particularité d'être configuré pour permettre l'obtention de cellules solaires avec une résistance accrue aux irradiations par les électrons et les protons.

Les inventeurs ont découvert que, de manière inattendue, un fort dopage du substrat 10 et en particulier avec une concentration en trous à l'équilibre (p₀) supérieure à 10¹⁷ cm⁻³, permettait à une cellule solaire dotée d'un tel substrat 10 d'avoir une résistance aux irradiations nettement améliorée.

Le substrat 10 est ainsi ici dopé pour créer un surplus de trous (i.e. un déficit d'électrons) dans la structure cristalline du silicium, au moyen d'au moins une espèce dopante permettant de créer ce surplus de trous. Cette espèce dopante peut être par exemple du Bore ou du Gallium ou de L'Aluminium. Le dopage de type p est effectué de sorte à avoir une concentration en trous à l'équilibre (p₀) supérieure à 10¹⁷ cm⁻³ et inférieure ou égale 10¹⁸ cm⁻³.

Selon une possibilité de mise en œuvre particulière, le dopage du silicium cristallin peut être réalisé par addition conjointe d'éléments dopants accepteurs distincts. Ainsi, par exemple, on peut prévoir un dopage p, à la fois au Bore et au Gallium.

Afin d'améliorer la résistance aux irradiations, outre le fort niveau de dopage p avec des éléments dopants accepteurs, d'autres types d'éléments dopants peuvent être également introduits dans le substrat c-Si. Ainsi, outre des dopants accepteurs, des impuretés « neutres » (isovalentes) peuvent être introduites dans le silicium. Par impuretés neutres on entend des éléments, en particulier des atomes, qui n'ajoutent pas de porteurs de charge libres (électron ou trou) au matériau du substrat.

On peut en variante ou en combinaison prévoir d'introduire des éléments dopants légers comme le lithium ou l'hydrogène.

On peut en variante ou en combinaison prévoir d'introduire des éléments qui peuvent présenter un état électriquement actif. Des éléments d'une espèce donneuse telle que par exemple de l'antimoine. Lorsqu'on introduit des éléments dopants ayant un caractère donneur, on s'assure néanmoins que le fort niveau de dopage de type p est globalement conservé. Ainsi, si l'on considère l'ajout d'une espèce D donneuse telle que par exemple, l'antimoine (Sb) dans le substrat 10 avec comme élément accepteur majoritaire A, par exemple du Bore, on veille à ce que la condition suivante soit remplie : p₀=[A⁻]-[D⁺], avec ici par exemple p₀=[B⁻]-[ Sb⁺] avec p₀ ∈ ]10¹⁷ cm⁻³ ; 10¹⁸ cm⁻³], [A⁻] et [D⁺] correspondant aux concentrations respectives d'atomes accepteurs et donneurs ionisés dans le cas général (on considère ici par souci de simplification que les espèces dopantes ne libèrent qu'une seule charge), et [B⁻] et [Sb⁺] aux concentrations respectives d'atomes de B et de Sb ionisés dans un exemple de réalisation particulier.

Avec un niveau de dopage tel que précité et de sorte à avoir une concentration en trous (p₀) à l'équilibre strictement supérieure à 10¹⁷ cm⁻³ on peut prévoir un substrat d'épaisseur e₁₀ relativement élevée comprise par exemple entre 60 µm et 120 µm, en particulier entre 80 µm et 120 µm et de préférence entre 90 µm et 120 µm tout en conservant un bon potentiel de rendement de conversion, c'est-à-dire un potentiel d'au moins 12,2% (spectre AM1.5G ; température de 300 K) pour une irradiation par des électrons d'énergie 1 MeV et une fluence de 1,5x10¹⁵ cm⁻² .

L'épaisseur e₁₀ du substrat 10 est une dimension donnée sur la figure 1 mesurée parallèlement à un axe z entre une première face principale également appelée « face avant » 12 et une deuxième face principale également appelée « face arrière » 14 opposée à la première face principale 12 du substrat 10.

Pour éviter la formation de complexes A-Oᵢ (A pour accepteur, i désignant une position interstitielle de l'atome dans le réseau cristallin), en particulier Bᵢ-Oᵢ et/ou Gaᵢ-Oᵢ, susceptibles de dégrader les performances de la cellule, en particulier en termes de réduction de la durée de vie de porteurs de charge, on prévoit en outre, conjointement à la concentration élevée en dopants, une faible concentration en oxygène, et en particulier inférieure à 3*10¹⁷ atomes * cm⁻³.

La concentration en oxygène dans le silicium cristallin du substrat 10 est typiquement comprise entre 10¹⁴ et 3x10¹⁷ atomes par cm³, de préférence entre 10¹⁴ et 9*10¹⁶ atomes par cm³.

Ainsi, la protection contre les effets d'irradiations notamment d'irradiations telles que rencontrées dans un environnement spatial prévoit ici à la fois un dopage p élevé et une faible concentration en oxygène. Une concentration en oxygène faible et selon une gamme précitée et une concentration en dopants p élevée et telle que précitée se retrouve dans tout le substrat, depuis sa face inférieure jusqu'à sa face supérieure et autrement dit sur toute son épaisseur.

On adapte ainsi les paramètres de fabrication du substrat pour obtenir de telles gammes.

Le dopage p peut être réalisé de manière conventionnelle, par exemple par un procédé *in situ* lors de la réalisation d'un lingot et avant découpe de ce lingot pour obtenir le substrat.

En ce qui concerne l'obtention d'une faible concentration en oxygène, on utilise ici de préférence un procédé différent d'un procédé effectué par tirage Czochralski conventionnel.

Une première méthode que l'on peut employer pour obtenir une faible concentration en oxygène est celle de la solidification dirigée en creuset également connue sous le nom de méthode de solidification unidirectionnelle et en particulier avec une cristallisation assistée par reprise sur germe connue sous la dénomination « Mono-like » ou « Cast-Mono ». Une telle méthode comprend une mise en creuset de silicium purifié. Le silicium est chauffé au-dessus de son point de fusion, par exemple à une température comprise entre 1410°C et 1550°C. Cette fusion est effectuée dans une atmosphère contrôlée. Le dopage est typiquement effectué pendant la phase de fusion du silicium. Le creuset contenant le silicium fondu est ensuite refroidi de manière contrôlée. On prévoit ici un revêtement intermédiaire, par exemple en nitrure de silicium, entre le creuset et le silicium. Ce revêtement limite les interactions entre le creuset, qui peut être en silice et source de contamination en oxygène, et le silicium. Une fois le silicium solidifié, un lingot est retiré du creuset. Le lingot résultant est ensuite découpé en plaquettes, c'est-à-dire en substrats tel que le substrat décrit précédemment. Cette méthode permet d'obtenir un substrat en silicium qui présente une structure majoritairement monocristalline mais avec quelques zones polycristallines. Cela signifie que la majorité du silicium présente des alignements cristallins uniformes, semblables à ceux du silicium monocristallin.

Une autre méthode pour réaliser un substrat en silicium avec une faible concentration en oxygène, cette fois monocristallin, peut employer une technique de cristallisation par zone fondue. Une telle méthode n'utilise pas de creuset en silice et repose sur le déplacement d'une zone fondue le long d'un barreau de silicium polycristallin, ici d'un barreau fortement dopé p avec une concentration en dopants permettant l'obtention d'une concentration en trous à l'équilibre entre 10¹⁷ cm⁻³ et 10¹⁸ cm⁻³. Elle procède par la fusion localisée du barreau de silicium polycristallin.

Une autre méthode pour fabriquer un substrat en silicium avec une faible concentration en oxygène, comprend la mise en œuvre d'un tirage Czochralski sous champ magnétique (MCz). Une telle méthode utilise un champ magnétique pour influencer la convection dans le silicium fondu. En appliquant un champ magnétique, il est possible de réduire les mouvements convectifs dans le silicium fondu, ce qui permet notamment de réduire l'incorporation d'oxygène dans le cristal. Lorsque le procédé est effectué en utilisant un creuset en silice, le champ magnétique aide à limiter l'érosion du creuset source d'oxygène et contenant le silicium fondu et/ou confiner des zones contenant de l'oxygène à proximité du creuset.

Une autre méthode pour fabriquer un substrat en silicium avec une faible concentration en oxygène prévoit de former ce substrat par croissance par épitaxie sur un support « parent » typiquement en silicium. On fait croitre une couche sur ce support « parent » et on effectue ensuite un détachement ultérieur de la couche épitaxiée. Le détachement est facilité par exemple en prévoyant une zone poreuse dans le substrat parent. Cette technique dite « kerf-less » s'affranchit de la formation d'un lingot et des étape de découpe qui en découlent. Elle ne fait pas interagir du silicium liquide avec une source d'oxygène comme avec un creuset en silice.

A partir d'un substrat 10 tel que décrit précédemment, certaines étapes sont prévues pour fabriquer une cellule solaire et notamment la réalisation d'au moins une jonction du côté de la face avant. Lorsque l'on forme une jonction par diffusion thermique ou implantation de dopants (l'implantation étant typiquement suivie d'un recuit) dans le silicium du substrat 10, tandis que p₀ augmente, la profondeur de jonction peut avoir tendance à diminuer. C'est en particulier le cas lorsqu'on réalise des cellules à homo-jonction. Afin d'éviter l'apparition d'effets de courts-circuits (« shunts ») de la jonction par une ou plusieurs électrodes (encore appelées grilles) métalliques en contact avec la surface du substrat c-Si, on peut former des contacts dits « passivés » au moins sur la face avant et de préférence du côté de la face avant 12 et de la face arrière 14 du substrat 10.

De tels contacts comprennent typiquement une couche de passivation directement en contact avec le substrat 10, et une couche sélective des porteurs de charge, ici d'électrons pour la face avant, réalisée sur la couche de passivation.

On forme ensuite une ou plusieurs couches en oxyde transparent conducteur (TCO), par exemple à base d'oxyde d'indium-étain (ITO) ou l'oxyde de zinc (ZnO), pour servir de contact transparent, permettant ainsi à la lumière d'entrer tout en collectant les charges électriques. On forme ensuite des grilles métalliques par exemple en argent. Une ou plusieurs couches de protection et/ou anti-reflet peuvent être également prévues.

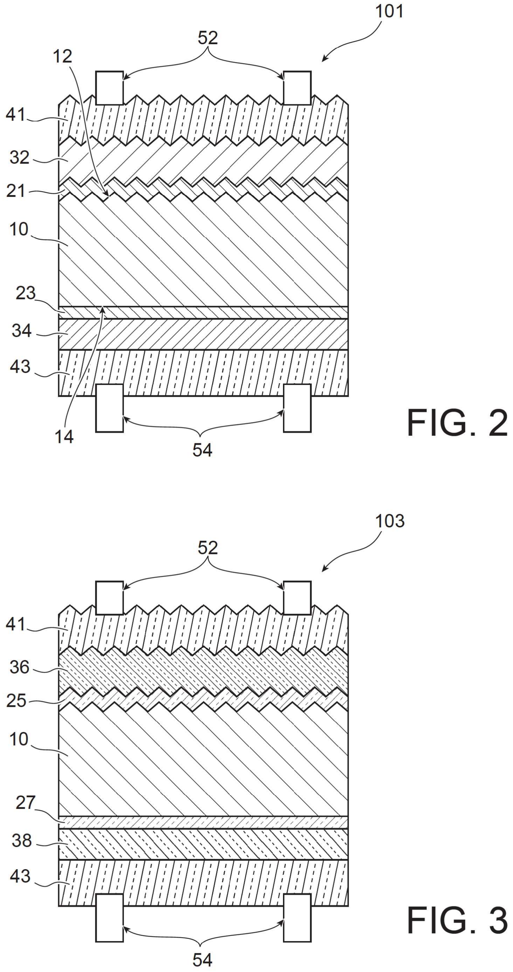

Un exemple de structure de cellule 101 solaire à hétérojonction dotée d'un substrat 10 tel que décrit précédemment, avec une concentration en trous à l'équilibre (p₀) strictement supérieure à 10¹⁷ cm⁻³ et une concentration en oxygène inférieure à 3*10¹⁷ atomes*cm⁻³, est donné sur la figure 2.

Dans cet exemple de réalisation particulier, afin de diminuer la réflectivité de la surface de la cellule 101 et d'augmenter le chemin optique de la lumière dans la cellule 101, une texturation de la face avant 12 du substrat 10 est prévue.

Une telle texturation est optionnelle et également possible en face arrière 14. La texturation est typiquement réalisée avant formation de la jonction, par exemple par action mécanique et/ou gravure plasma et/ou ou par attaque chimique, par exemple à l'aide d'une solution de KOH. Il est également possible de réaliser la texturation sur les deux faces 12, 14 puis ensuite d'effectuer un polissage de la face arrière par voie chimique, afin de conserver une face arrière 14, plane. Un nettoyage des faces principales 12, 14 par exemple à l'aide de HF/HCl peut être ensuite mis en œuvre.

Dans l'exemple de réalisation illustré sur la figure 2, la cellule 101 comporte une première couche de passivation 21 sur et en contact avec la face avant 12 du substrat 10 et une deuxième couche de passivation 23 sur et en contact avec la face arrière 14 du substrat 10. Les couches de passivation 21, 23 ont typiquement une faible épaisseur comprise par exemple entre 1 nm et 10 nm et sont par exemple en silicium amorphe intrinsèque a-Si(i).

La première couche de passivation 21 est revêtue d'une couche 32 sélective d'électrons pour former une jonction pn avec le substrat. La couche 32 sélective d'électrons d'épaisseur comprise par exemple entre 2 nm et 40 nm, peut être en particulier une couche de silicium amorphe dopé n (a-Si (n)), ou une couche de silicium nano-cristallin dopé n. Par « nano-cristallin » on fait référence ici à une forme de silicium où les cristaux individuels (ou grains) ont une taille nanométrique, typiquement de l'ordre de plusieurs nanomètres à plusieurs dizaines de nanomètres.

L'autre couche de passivation 23 est, quant à elle, revêtue d'une couche 34 sélective de trous, en particulier une couche de silicium amorphe dopé p (a-Si (p)) d'épaisseur comprise par exemple entre 2 nm et 40 nm.

Chacune des couches 32, 34 est revêtue d'une couche à base d'oxyde transparent conducteur (TCO), par exemple à base d'oxyde d'indium-étain (ITO) d'épaisseur comprise par exemple entre 5 nm et 150 nm.

Des grilles métalliques 52, 54 par exemple en argent sont prévues respectivement sur la couche 41 d'oxyde transparent conducteur (TCO) et l'autre couche 43 d'oxyde transparent conducteur (TCO).

Un autre exemple de cellule 103 est donné sur la figure 3 et diffère du précédent notamment de par la composition des contacts passivés.

La cellule 103 comporte une première couche de passivation 25 disposée sur et en contact avec la face avant 12 du substrat 10 et une deuxième couche de passivation 27 disposée sur et en contact avec la face arrière 14 du substrat 10, dans cet exemple à base d'oxyde de silicium SiOₓ. Les couches de passivation 25, 27 ont une épaisseur comprise par exemple entre 1 nm et 5 nm.

La couche de passivation 25 est revêtue ici d'une couche 36 sélective d'électrons, qui avec le substrat 10 dopé p, permet de former une jonction. La couche 36 sélective d'électrons est ici en polysilicium (ou silicium poly-cristallin) dopé n (poly-Si (n)), d'épaisseur comprise par exemple entre 5 nm et 90 nm.

L'autre couche de passivation 27 est ici revêtue d'une couche 38 sélective de trous, cette fois en polysilicium dopé p (poly-Si(p)) d'épaisseur comprise par exemple entre 5 nm et 90 nm.

Pour améliorer la transparence des contacts passivés, on peut prévoir d'introduire des atomes d'oxygène et/ou de carbone dans la ou les couches de passivation 21, 23, 25, 27 et/ou dans la ou les couches sélectives de charges 32, 34, 36, 38.

Les performances d'une cellule telle que la cellule 103 de la figure 3, dotée d'un substrat 10 à base de c-Si revêtue de SiOₓ sur ses deux faces 12, 14, ainsi que d'une couche de poly-Si dopé n sur la face avant et une couche de poly-Si dopé p sur la face arrière, ont été évaluées après irradiation par des électrons.

Une telle irradiation a été modélisée par le biais du logiciel de simulation numérique PC1D. En particulier, les effets de diffusion des dopants du phosphore pour la couche 36 sur la face avant et du bore pour la couche 38 sur la face arrière, ont été pris en compte dans le modèle. Les propriétés optiques du dispositif ont été modélisées en s'appuyant sur le logiciel OPAL et des résultats expérimentaux tenant compte de variation expérimentale de la densité de courant de court-circuit avec l'épaisseur du substrat 10.

Enfin, les mécanismes de recombinaison des porteurs de charge post-irradiation ont été modélisés par des recombinaisons de type Shockley-Read-Hall en utilisant des paramètres de défauts tels que la position en énergie dans la bande interdite, le rapport des sections efficaces de capture des trous et des électrons, comme les paramètres présentés par exemple dans le document « Effect of illumination intensity on cell parameters of a silicon solar cell », Khan et al, SolMat, 2019.

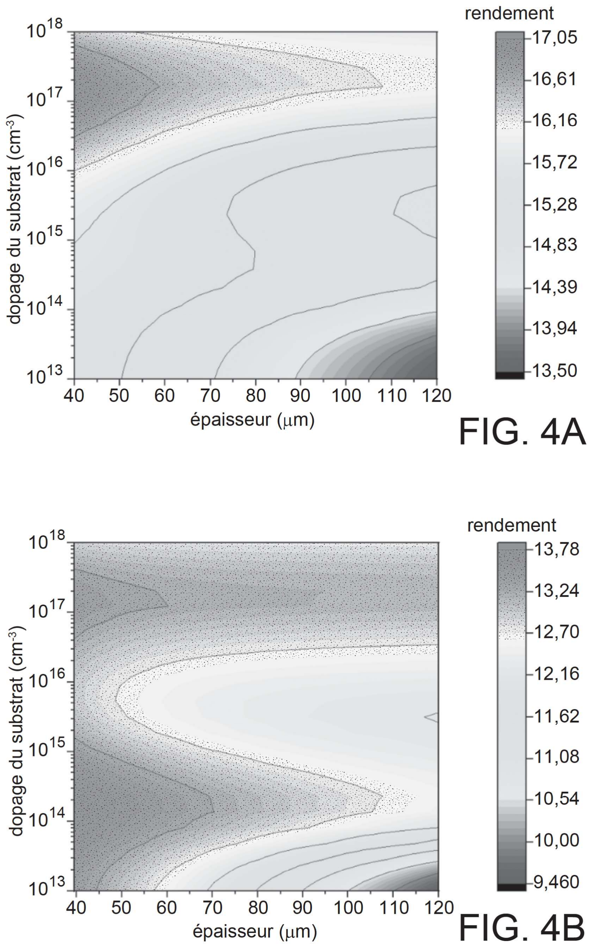

La pertinence du modèle de cellule développé a été validée en confrontant les résultats des simulations PC1D avec les paramètres PV de cellules irradiées. Les figures 4A et 4B donnent des résultats de simulations lancées sur la base du modèle précité en faisant varier l'épaisseur du substrat 10, et le paramètre p₀, sur de larges plages de valeurs et ce, respectivement pour une première fluence d'irradiation par des électrons (énergie 1 MeV) de 1,5*10¹⁴ cm⁻² (figure 4A) et pour une deuxième fluence d'irradiation par des électrons (énergie 1 MeV) de 1,5*10¹⁵ cm⁻² (figure 4B).

De façon inattendue par rapport à ce que suggérait l'état de l'art, ces résultats mettent en évidence des zones correspondant à des forts p₀ (en particulier supérieurs à 10¹¹ cm⁻³), soit des résistivités <0,2 Ω.cm, pour lesquelles les cellules présentent une résistance accrue aux irradiations en démontrant des rendements plus élevés.

On constate également qu'avec de tels niveaux de p₀, il est possible d'utiliser des échantillons d'épaisseur relativement élevée, entre 90 µm et 120 µm tout en conservant de bons rendements de conversion. Or, avec une telle épaisseur de cellules photovoltaïques des risques de déformation et/ou de casse sont réduits.

Une application particulière d'une cellule solaire telle que décrite précédemment concerne les modules photovoltaïques destinés à être utilisés dans l'espace par exemple dans un satellite, une station spatiale, un véhicule spatial, une sonde, une centrale photovoltaïque en orbite, un bâtiment de base lunaire ou martienne.

## Revendications

1. Cellule solaire (101, 103) adaptée à une utilisation dans l'espace comprenant un substrat (10) en silicium cristallin et ayant une conductivité de type p, le substrat étant avec une épaisseur (e₁₀) mesurée d'une première face principale à une deuxième face principale, comprise entre 20 µm et 180 µm, le substrat étant dopé à l'aide d'au moins une espèce dopante de type accepteur dans le silicium, de manière à ce que la concentration de trous à l'équilibre p₀ soit strictement supérieure à 10¹⁷ cm⁻³, le substrat ayant une concentration en oxygène inférieure à 3*10¹⁷ atomes par cm³ et typiquement comprise entre 10¹⁴ et 10¹⁷ atomes par cm³ pour lui conférer une résistance accrue aux irradiations.

2. Cellule solaire (10) selon la revendication 1, le substrat (10) étant en silicium monocristallin ou majoritairement monocristallin.

3. Cellule solaire (10) selon la revendication 1 ou 2, l'espèce dopante de type accepteur étant choisie parmi : B, Ga, AI.

4. Cellule solaire (10) selon l'une des revendications 1 à 3, le substrat (10) étant dopé en outre :
- à l'aide d'au moins une espèce neutre telle que du germanium ou de l'étain et/ou
- à l'aide d'un élément léger tel que de l'hydrogène ou du lithium et/ou
- à l'aide d'une espèce de type donneur telle que de l'antimoine.

5. Cellule solaire (10) selon l'une des revendications 1 à 4, dans lequel le substrat (10) a une épaisseur (e₁₀) comprise entre 40 µm et 120 µm, de préférence entre 60 et 120 µm et encore avantageusement entre 80 et 120 µm.

6. Cellule solaire (101, 103) selon l'une des revendications précédentes, la concentration de trous à l'équilibre p₀ étant supérieure à 1.5*10¹⁷ cm⁻³, la concentration en oxygène étant inférieure ou égal à 10¹⁷ atomes par cm³ et de préférence inférieure à 9*10¹⁶ atomes par cm³

7. Cellule solaire (101, 103) selon l'une des revendications précédentes, comprenant en outre au moins un empilement de contact passivé sur une première face du substrat, l'empilement de contact passivé étant formé :
- d'une couche (21, 25) de passivation, telle qu'une couche en oxyde de silicium ou en silicium amorphe intrinsèque a-Si(i), directement en contact avec la première face (12),
- d'une couche (32, 36) sélective d'électrons, en particulier une couche de silicium amorphe dopé n, ou une couche de silicium nanocristallin dopé n, ou une couche de silicium polycristallin dopé n, directement en contact avec la couche (21, 25) de passivation.

8. Cellule solaire (101, 103) selon la revendication 7, comprenant au moins un autre empilement de contact passivé sur une deuxième face (14) du substrat (10) opposée à la première face (10), l'autre empilement de contact passivé étant formé :
- d'une autre couche (23, 27) de passivation, telle qu'une couche en oxyde de silicium ou en silicium amorphe intrinsèque a-Si(i), directement en contact avec la deuxième face,
- d'une couche (34, 38) sélective de trous, en particulier une couche de silicium amorphe dopé p, ou une couche de silicium nanocristallin dopé p, ou une couche de silicium polycristallin dopé p, directement en contact avec la couche (23, 27) de passivation.

9. Cellule solaire (101, 103) selon l'une des revendications 7 ou 8, dans lequel l'empilement de contact passivé est revêtu :
- d'au moins une couche d'au moins un oxyde transparent conducteur (41, 43), des électrodes métalliques (52, 54) étant agencées sur la couche d'oxyde transparent conducteur.

10. Module photovoltaïque pour dispositif spatial tel qu'un satellite une station spatiale, un véhicule spatial, une sonde, un bâtiment comprenant une ou plusieurs cellules solaires selon l'une des revendications précédentes.

11. Procédé de fabrication d'un substrat d'une cellule selon l'une des revendications 1 à 9, la réalisation du substrat comprenant l'une des méthodes suivantes :
- Solidification dirigée en creuset ou ;
- Croissance par épitaxie sur un support parent doté d'une couche poreuse puis détachement du support poreux ou ;
- Cristallisation par zone fondue ;
- Tirage Czochralski effectué sous champ magnétique.
